Europäisches Patentamt

European Patent Office

Office européen des brevets

(19)

(11) Veröffentlichungsnummer: **0 003 759**
**B1**

(12) **EUROPÄISCHE PATENTSCHRIFT**

(45) Veröffentlichungstag der Patentschrift:
05.05.82

(51) Int. Cl.³: **H 01 L 21/00**, G 03 F 7/02

(21) Anmeldenummer: 79100278.5

(22) Anmeldetag: 31.01.79

(54) Verfahren zur Belichtung einer strahlungsempfindlichen Schicht durch Röntgenstrahlen.

(30) Priorität: 22.02.78 DE 2807478

(43) Veröffentlichungstag der Anmeldung:
05.09.79 Patentblatt 79/18

(45) Bekanntmachung des Hinweises auf die Patenterteilung:
05.05.82 Patentblatt 82/18

(84) Benannte Vertragsstaaten:
DE FR GB

(56) Entgegenhaltungen:
EP-A-0 001 030
FR-A-2 070 899
US-A-3 849 136

SOLID STATE TECHNOLOGY, Vol. 20, Nr. 5, 1977 New York,
G.P. HUGUES: «X-ray lithography for IC-processing»,
Seiten 39–42

ELECTRONICS, Vol. 47, Nr. 17, 22. August 1974, New York,
«X-ray lithography inches closer», Seiten 80–81

IBM TECHNICAL DISCLOSURE BULLETIN, Vol. 21, Nr. 5, Oktober 1978, New York,
B.J. Lin: «Portable intimately contacted mask», Seite 2133

(73) Patentinhaber: International Business Machines Corporation, Armonk, N.Y. 10504 (US)

(72) Erfinder: Bohlen, Harald, Geleener Strasse 26, D-7030 Böblingen (DE)
Erfinder: Greschner, Johann, Dr., Zollernstrasse 14, D-7401 Pliezhausen (DE)
Erfinder: Kulcke, Werner, Dr., Westerwaldweg 8, D-7030 Böblingen (DE)
Erfinder: Nehmiz, Peter, Dr., Adlerstrasse 7, D-7030 Böblingen (DE)

(74) Vertreter: Teufel, Fritz, Dipl.-Phys., Schönaicher Strasse 220, D-7030 Böblingen (DE)

Verfahren zur Belichtung einer strahlungsempfindlichen Schicht durch Röntgenstrahlen

Die Erfindung betrifft ein Verfahren zur Belichtung einer strahlungsempfindlichen Schicht mit Röntgenstrahlen.

Bei der Herstellung von integrierten Halbleiterschaltungen werden die in jedem Verfahrensschritt zu bearbeitenden Bereiche der Halbleiterplättchen durch mit den jeweils erforderlichen Mustern belichtete und anschliessend entwickelte Photolackschichten definiert. Nachdem mit fortschreitender Miniaturisierung die etwa bei 2 µm liegende Grenze des Auflösungsvermögens der bisher ausschliesslich verwendeten, Strahlungen mit Wellenlängen im Bereich zwischen 0,3 µm und 0,7 µm benutzenden Verfahren erreicht und teilweise schon überschritten wurde, ist man in letzter Zeit zu Verfahren übergegangen, bei denen die Belichtung mit Elektronenstrahlen oder Röntgenstrahlen erfolgt.

Nun ist das Auflösungsvermögen bei Belichtung mit Elketronenstrahlen oder Röntgenstrahlen sehr hoch – theoretisch können Linien mit Breiten von 0,1 µm und darunter übertragen werden – diese Strahlen weisen aber eine Reihe von Nachteilen auf, die ihre Verwendbarkeit bei der industriellen Herstellung von integrierten Schaltungen einschränken. Die wesentlichen Nachteile bei der Verwendung von Elektronenstrahlen beruhen auf der Tatsache, dass die Elektronen in der strahlungsempfindlichen Schicht gestreut werden, so dass insbesondere bei schmalen Strukturen eine starke Verbreiterung der belichteten Bereiche stattfindet. Diese Erscheinung ist besonders bei sehr kleinen Abständen zwischen den einzelnen belichteten Bereichen sehr störend, da durch die ungewollten und nicht genauf definierbaren Verbreiterungen Kontakte zwischen benachbarten Strukturen entstehen können, durch die die hergestellten integrierten Schaltungen unbrauchbar werden. Nur durch aufwendig errechnete Musteroder Belichtungsdosisvariationen kann sichergestellt werden, dass die gewünschten Dimensionen der Muster nach der Entwicklung auch erreicht werden. Die Streuung der Elektronen ist auch dafür verantwortlich, dass das Verhältnis Photolackschicht zur kleinsten Linienbreite den Wert 1 nicht übersteigen kann. Da für die der Belichtung und Entwicklung folgenden Ätz- oder Implantationsvorgänge jedoch Photolackschichten mit einer Dicke von mindestens 1 µm unerlässlich sind, ist die Verwendung von Elektronenstrahlen allein für die Submikronlithographie praktisch ausgeschlossen.

Die obengenannten Nachteile treten bei der Verwendung von Röntgenstrahlen zur Belichtung von Photolackschichten nicht auf, da bei Röntgenstrahlbelichtung das Verhältnis von Linienbreite zur Dicke der Photolackschicht kleiner als 1 : 10 sein kann. Röntgenstrahlen können aber nicht gebündelt werden, und die zur Verfügung stehenden Röntgenstrahlquellen erzeugen Strahlenkegel, deren Öffnungswinkel bei 60° liegen, was zur Folge hat, dass in Entfernungen von der Röntgenstrahlquelle, in denen eine auch nur angenähert parallele Strahlung vorliegt, die Intensitäten so klein sind, dass Belichtungszeiten von vielen Stunden und selbst Tagen erforderlich sind. Diese langen Belichtungszeiten werden noch dadurch ganz wesentlich verlängert, dass es keine Maskensubstrate gibt, die selbst bei Dicken von 3 µm und weniger mehr als 50% der Röntgenstrahlung durchlassen. Bei der Herstellung von integrierten Halbleiterschaltungen ist es daher nicht möglich, mit Röntgenstrahlen jeweils nur kleine Bereiche, beispielsweise Chipbereiche zu belichten. Man muss vielmehr, um auch nur einigermassen wirtschaftlich zu arbeiten, den gesamten Strahlenkegel der Röntgenquelle ausnutzen, d.h. gleichzeitig mehrere hundert Halbleiterplättchen (Wafer), d.h. 20 000 bis 100 000 Chips belichten. Die an sich wünschenswerte Belichtung jeweils nur kleiner Bereiche auf dem Halbleiterplättchen (Wafer) – z.B. in der Grösse eines oder weniger Chips – ist bei der Vielzahl der notwendigen hochgenauen Ausrichtungen und wegen der schlechten Ausnutzung des Röntgenstrahlenkegels wirtschaftlich nicht vertretbar. Da die gleichzeitige Belichtung eines ganzen Wafers mit Röntgenstrahlen wegen der unvermeidlichen Verwerfungen der Wafer Abstände zwischen Maske und Wafer von mindestens 30 bis 50 µm erforderlich machten, treten in der Praxis so viele Fehlbelichtungen auf, dass gleichzeitige Belichtungen von mehreren hundert Halbleiterplättchen bei der industriellen Herstellung von integrierten Halbleiterschaltungen mit Submikronstrukturen nicht möglich sind. Es darf dabei nicht übersehen werden, dass die bei stark divergenten Strahlen örtlich stark unterschiedliche seitliche Versetzung eines durch schräg einfallende Strahlen übertragenen Maskenbildes zwar durch entsprechende Massnahmen bei der Maskenherstellung kompensiert werden kann, dass aber durch reversible oder irreversible örtliche Längenänderungen der Masken und/oder der Halbleiterplättchen oder durch örtliche Abstandsänderungen Ausrichtfehler entstehen, die in der Grössenordnung von einigen µm liegen. Es ist daher offensichtlich, dass die bisher bekannten Verfahren zur Belichtung mit Röntgenstrahlen für die grossindustrielle Herstellung von integrierten Halbleiterschaltungen mit Linienelementen im Submikronbereich nicht verwendbar sind, obwohl bei der Entwicklung von durch Röntgenstrahlen belichteten Photolackschichten Kanäle mit senkrechten glatten Wänden erzeugt werden können, deren Breite kleiner als ein Zehntel der Dicke der Photolackschicht ist.

Aus der älteren, nicht vorveröffentlichten europäischen Patentanmeldung mit Veröffentlichungsnummer 0 001 030 ist zwar ein Verfahren zur Herstellung einer Maske für Röntgenstrahlbelichtung bekannt geworden, bei dem eine über der röntgenstrahlempfindlichen Photolackschicht angeordnete Metallschicht als Maske dient und dazu mit Hilfe eines elektronenstrahl-lithographischen

2

Prozesses strukturiert wird. Der kleine Abstand Maske–Substrat verringert zwar die Abbildungsfehler, doch ist auch hier kein Mittel erkennbar, wie lokale Längenänderungen des Substrats oder der Maske unschädlich gemacht werden können. Die bisher bekanntgewordenen Verfahren zur Ausrichtung von Maske und Substrat bei der Elektronenstrahllithographie, bei denen mehrere Ausrichtmarkierungen auf einem Halbleitersubstrat in vorgewählten Bereichen für die Ausrichtung eines Elektronenstrahls angebracht sind (vgl. französische Patentschrift 2 070 899), sind in ihrer Ausrichtgenauigkeit beschränkt, da die Masken während des Herstellprozesses vor der Ausrichtung durch weitere Schichten, z. B. Photolackschichten, überdeckt werden, die wiederum Anlass zu Streueffekten und einer Verfälschung des Elektronenstrahlsignals führen. Bei direkter Anwendung der oben erwähnten, auf Photolackschichten erzeugten Metallmasken für Röntgenstrahllithographie sind derartige Masken überhaupt nicht brauchbar, da sie von der Metallschicht vollkommen abgedeckt werden.

Die vorliegende Erfindung erstellt sich daher die Aufgabe, ein Lithographieverfahren anzugeben, bei dem alle Vorteile der Elektronenstrahllithographie und der Röntgenstrahllithographie vereinigt sind, deren Nachteile aber vermieden werden und bei dem eine genaue Ausrichtung der einzelnen, zu belichtenden Bereiche ermöglicht wird.

Diese Aufgabe wird durch die im Anspruch 1 beschriebene Erfindung gelöst.

Die Erfindung geht von der Aufgabe aus, ein Verfahren zur Belichtung von lichtempfindlichen Schichten anzugeben, bei dem alle Vorteile der Belichtungen mit Elektronenstrahlen und Röntgenstrahlen erhalten, ihre Nachteile aber vermieden werden und das eine genaue Ausrichtung ermöglicht. Diese Aufgabe wird durch die im Anspruch 1 beschriebene Erfindung gelöst. Durch Belichten der obersten dünnen Schicht mit Elektronenstrahlen und Freilegen der darunterliegenden Metallschicht durch einen sich anschliessenden Entwicklungsschritt, dem sich ein Ätzvorgang anschliesst, wird eine für die nachfolgenden Röntgenstrahlbelichtung geeignete, sehr fein strukturierte Maske erzeugt, die ein genaues Abbild des durch Elektronenstrahlen erzeugten Belichtungsmusters ist. Da die oberste Schicht sehr dünn sein kann – Photolackschichten von 0,3 µm und weniger, haben sich für das Ätzen der Metallschicht als durchaus ausreichend erwiesen – treten die in den oben beschriebenen dicken Photolackschichten durch gestreute Elektronen verursachten unkontrollierbaren Verbreiterungen der Linien nicht auf. Das trifft insbesondere bei der Belichtung mit gering beschleunigten Elektronen, wie z. B. beim Elektronenstrahl-Schattenwurf durch Komplementärmasken zu. Durch geeignete relativ einfache, im folgenden noch zu beschreibende Massnahmen ist es weiterhin möglich, die Metallschicht nur im Bereich der zu erzeugenden Einzelschaltungen (Chips) aufzubringen und die dazwischenliegenden, nicht zur Aufnahme von Schaltungen bestimmten Bereiche des Halbleiterplättchens durch Entfernung beider Photolackschichten, freizulegen, so dass die in diesen Bereichen aufgebrachten Markierungen für Elektronenstrahlausrichtung durch an sich bekannte Vorrichtungen und Verfahren für eine extrem genaue automatische Ausrichtung ausgenützt werden können. Auf diese Weise wird es möglich, das Elektronenstrahlbelichtungssystem jeweils auf kleine Bereiche mit der bei Verwendung von Elektronenstrahlen möglichen extrem hohen Genauigkeit auszurichten.

Die auf diese Weise mit hoher Geschwindigkeit, höchstem Auflösungsvermögen und extrem hoher Ausrichtgenauigkeit erzeugten Masken sind mit dem Halbleiterplättchen durch eine Photolackschicht verbunden, deren Dicke in Abhängigkeit von den Anforderungen der anschliessenden Verfahrensschritte 1 bis 3 µm beträgt und mit bekannten Massnahmen bis auf wenige Prozent konstant gehalten werden kann. Auf diese Weise ist es möglich, die nachfolgende Röntgenstrahlbelichtung mit relativ stark divergenten Röntgenstrahlbündeln durchzuführen, was bedeutet, dass die Röntgenstrahlquellen zur Erzeugung hoher Strahlungsintensitäten im Bereich der Halbleiterplättchen in wesentlich geringeren Abständen von diesen als bei allen bisher bekannten Röntgenstrahlbelichtungsverfahren angeordnet werden können. Wegen des mit grosser Genauigkeit konstant gehaltenen, sehr kleinen Abstandes zwischen Maske und Halbleiterplättchen – der Abstand zwischen Maske und Photolackschicht ist praktisch gleich Null – können im Gegensatz zu den bisher erforderlichen möglichst punktförmigen und daher schwachen Röntgenstrahlquellen sehr grossflächige und damit sehr intensive Röntgenstrahlquellen verwendet werden. Gegenüber den bisher bekannten Röntgenstrahlbelichtungsverfahren, bei denen, wie oben erläutert, zur Vermeidung zu grosser Divergenzwinkel die Entfernung zwischen Lichtquelle und Halbleiterplättchen in der Regel 1 bis 3 m betragen musste, weist das erfindungsgemässe Verfahren schon aus diesem Grunde ganz erhebliche Vorteile auf. Da die durch Elektronenstrahlbelichtung und nachfolgende Entwicklung und Ätzung aus der zwischen den beiden Photolackschichten angeordneten Metallschicht hergestellte Röntgenstrahlmaske mit den Halbleiterplättchen durch die röntgenstrahlempfindliche Photolackschicht fest verbunden ist, können auch keine durch unterschiedliche seitliche Ausdehnung der Maske und/oder des Halbleiterplättchens auftretende Störungen entstehen.

Das erfindungsgemässe Verfahren vereinigt daher nicht nur die Vorteile der bisher bekannten Elektronenstrahl- und Röntgenstrahlbelichtungsverfahren, ohne ihre Nachteile in Kauf nehmen zu müssen, sondern verbessert die bekannten Röntgenstrahlbelichtungsverfahren zusätzlich noch dadurch, dass die zur Belichtung zur Verfügung stehenden Strahlungsintensitäten um mindestens eine Zehnerpotenz erhöht werden.

Die Erfindung wird anschliessend anhand der Figuren näher erläutert.

Es zeigen:

Fig. 1 eine Schnittansicht durch ein zur Durchführung des erfingungsgemässen Verfahrens beschichtetes Halbleiterplättchen,

Fig. 2 Schnittansichten zur Veranschaulichung der einzelnen Verfahrensschritte,

Fig. 3 eine schematische Darstellung der Verteilung der mit integrierten Schaltungen zu versehenden Bereiche und der dazwischenliegenden, Ausrichtmarkierungen enthaltenden Bereiche eines Halbleiterplättchens,

Fig. 4 eine Schnittansicht durch Fig. 3 entlang einer Line 4–4,

Fig. 5 Schnittansichten zur Veranschaulichung einer besonders vorteilhaften Weiterbildung dieses erfindungsgemässen Verfahrens,

Fign. 6 und 7 Masken zur Durchführung des erfindungsgemässen Verfahrens.

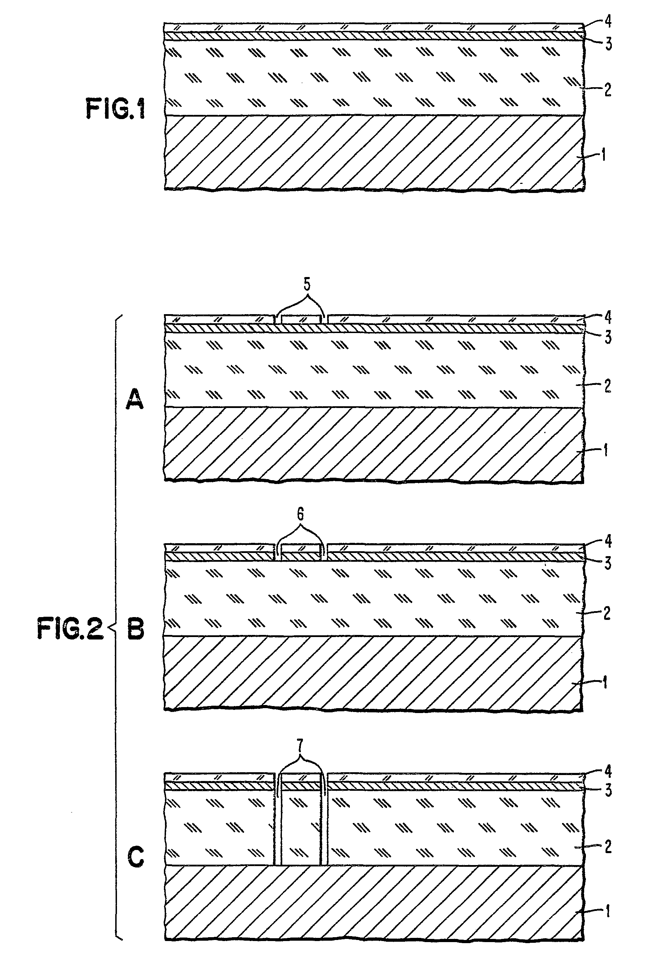

Gemäss Fig. 1 wird auf ein Halbleiterplättchen 1 durch an sich bekannte Verfahren, beispielsweise durch Aufbringen einer geeigneten Menge von Photolack und anschliessendes Schleudern, eine 1 bis 3 µm dicke röntgenstrahlempfindliche Photolackschicht 2 aufgebracht, deren örtliche Dickenänderungen im Bereich von 5% bis höchstens 10% liegen. Anschliessend wird auf diese Schicht eine vorzugsweise aus Gold bestehende Schwermetallschicht 3, beispielsweise durch Aufdampfen, aufgebracht, deren Dicke etwa 0,1 bis 0,5 µm beträgt. Auf die Schicht wird eine etwa gleich dicke Schicht 4 aus einem elektronenstrahlempfindlichen Photolack aufgebracht.

Anschliessend wird die oberste Schicht 4 durch an sich bekannte Verfahren mittels langsamer Elektronenstrahlen mit den auf das Halbleiterplättchen 1 zu übertragenden Mustern belichtet und anschliessend entwickelt, so dass, wie in Fig. 2A dargestellt, die Schwermetallschicht 3 in Bereichen 5 freigelegt wird.

Anschliessend wird die Schwermetallschicht 3 in den Bereichen 5, beispielsweise durch Trockenätzen, entfernt, um die röntgenstrahlempfindliche Schicht 2 in den in Fig. 2B mit 6 bezeichneten Bereichen freizulegen. Die Schicht 2 wird dann durch Beaufschlagung mit Röntgenstrahlen durch die nunmehr als Maske dienende Schwermetallschicht 3 hindurch belichtet und anschliessend entwickelt. Dabei entstehen, wie in Fig. 2C als Schnittansicht dargestellt, senkrechte Kanäle 7, die nahezu vollkommen ebene, senkrecht zur Oberfläche des Halbleiterplättchens 1 verlaufende Wände haben und somit ein genaues Abbild der in der als Maske dienenden Schwermetallschicht 3 befindlichen Ausnehmungen 6 darstellen. Für die nachfolgende Behandlung der freigelegten Bereiche des Halbleiterplättchens 1 werden zweckmässigerweise die stehengebliebenen Bereiche der Schwermetallschicht 3 entfernt, um eine Verunreinigung des Halbleiterplättchens 1 durch die Schwermetallschicht zu vermeiden. In anderen Fällen kann es aber zweckmässig sein, die stehengebliebenen Bereiche der Schwermetallschicht 3 auf der Schicht 2 zu belassen.

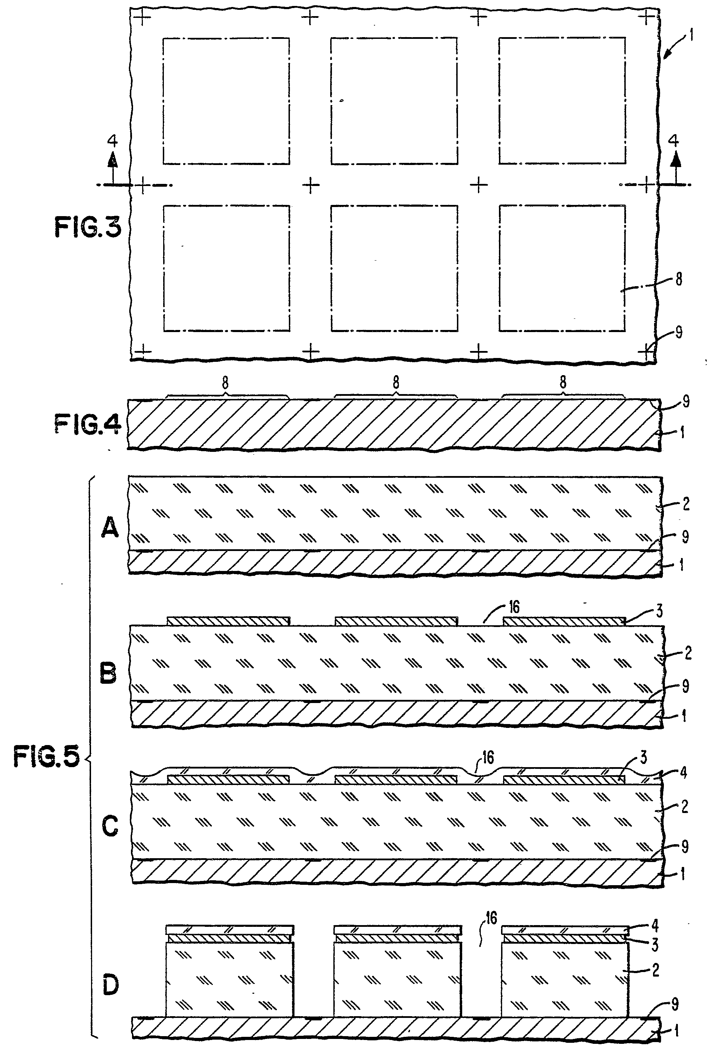

In Fig. 3 wird die Oberfläche eines Halbleiterplättchens 1 mit den darauf befindlichen, zur Aufnahme von funktionsfähigen Schaltungen vorgesehenen Bereichen (Chips) 8 und mit in den dazwischenliegenden Bereichen angeordneten Ausrichtmarkierungen 9 dargestellt. Fig. 4 stellt eine Schnittansicht des in Fig. 3 dargestellten Halbleiterplättchens entlang einer Linie 4–4 dar.

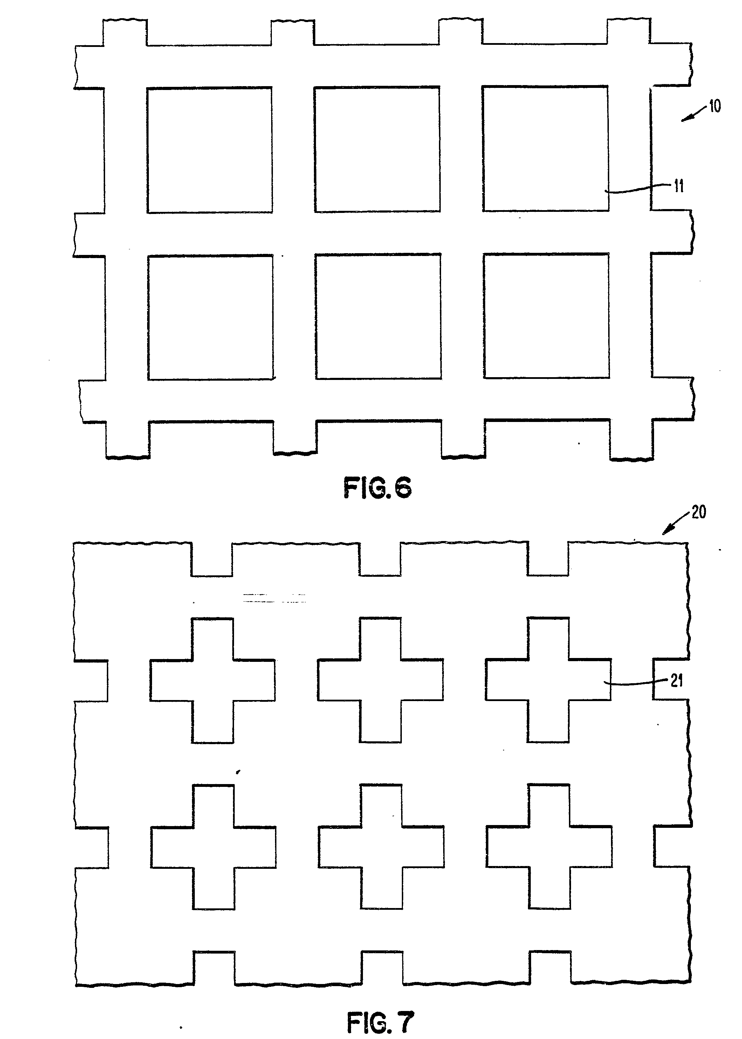

Auf das durch Aufbringung der Ausrichtmarkierungen 9 vorbereitete Halbleiterplättchen 1 wird, wie aus Fig. 5A ersichtlich, zur Durchführung des in den Fig. 1 und 2 dargestellten Verfahrens die etwa 1 bis 3 µm dicke röntgenstrahlempfindliche Photolackschicht 2 aufgebracht. Im nächsten Verfahrensschritt werden, wie aus Fig. 5B ersichtlich, in den mit Halbleiterschaltungen zu versehenden Bereichen 8 mit Hilfe einer in Fig. 6 dargestellten und entsprechende Ausnehmungen 11 aufweisenden Maske 10 entsprechend geformte Bereiche der Schwermetallschicht 3, beispielsweise durch Aufdampfen aufgebracht, zwischen denen die auf der Oberfläche des Halbleiterplättchens 1 angeordneten Ausrichtmarkierungen 9 liegen. Anschliessend wird diese Anordnung, wie in Fig. 5C dargestellt, mit der elektronenstrahlempfindlichen Photolackschicht 4 überzogen, und diese in den zwischen den im vorhergehenden Verfahrensschritt aufgebrachten Bereichen der Schicht 3 liegenden Flächen durch die in Fig. 7 dargestellten Ausnehmungen 21 aufweisende Maske 20 belichtet. Durch eine anschliessende Entwicklung werden die durch die Maske 20 definierten Bereiche 21 des Halbleiterplättchens 1 freigelegt, so dass die Ausrichtung der zur Belichtung der stehengebliebenen Bereiche der elektronenstrahlempfindlichen Photolackschicht 4 verwendeten, nicht dargestellten Masken mit Hilfe der Ausrichtmarkierungen 9 und einer nicht dargestellten, mit Elektronenstrahlen arbeitenden Ausrichtvorrichtung mit einer dem Auflösungsvermögen der Elektronenstrahlbelichtung entsprechenden Genauigkeit erfolgen kann. Es ist leicht einzusehen, dass an die Lagegenauigkeit der stehengebliebenen Bereiche 8 der Schichten 2, 3 und 4 nur geringe Anforderungen gestellt werden, da die Ausrichtmarkierungen 9 nur einen Bruchteil der durch die Ausnehmungen 16 definierten Bereiche einnehmen und etwa in ihrer Mitte liegen. An die Lagegenauigkeit der stehengebliebenen Bereiche der Schichten 2, 3 und 4 werden somit nur relativ geringe Anforderungen gestellt; die zulässigen Toleranzen werden in der Regel bei ±30 µm liegen. Es wird darauf hingewiesen, dass in den Figuren die Dicken der einzelnen Schichten sowie die Zwischenbereiche 16 und die Ausrichtmarkierungen 9 zwecks Erhöhung der Übersichtlichkeit und Vereinfachung der Darstellung stark vergrössert wiedergegeben sind.

Es ist ohne weiteres einzusehen, dass die Belichtung der in Fig. 5D dargestellten stehengebliebenen Bereiche der elektronenstrahlempfindlichen Photolackschicht 4 nach extrem exakter Ausrichtung mit Hilfe der Ausrichtmarkierungen 9 unter Verwendung an sich bekannter Verfahren mit grosser Geschwindigkeit einzeln erfolgen kann. Da die nach Entwicklung der belichteten Schicht 4 und einem anschliessenden Ätzvorgang Röntgenmasken darstellenden Bereiche 8 (Fig. 4) der Schwermetallschicht 3 mit dem Halbleiterplättchen 1 durch die nur etwa 1 bis 3 µm dicke röntgenstrahlempfindliche Schicht 2 fest verbunden sind, sind Änderungen des Abstandes sowie der seitlichen Relativlage zwischen der als Maske dienenden Schwermetallschicht 3 und der Oberfläche des Halbleiterplättchens 1 sowohl während der Einbringung der Halbleiterplättchen in die Röntgenstrahlbelichtungsvorrichtung als auch während des Belichtungsvorganges ausgeschlossen. Da die im Bereich des Halbleiterplättchens zur Verfügung stehenden Röntgenstrahlintensitäten – wegen des sehr kleinen und konstanten Abstandes zwischen der Schicht 3 und dem Halbleiterplättchen 1 sowie wegen der unveränderlichen Relativlage beider Schichten können, wie oben erläutert, sehr grossflächige und daher äusserst energiereiche Röntgenstrahlquellen in relativ kleinen Abständen von den zu belichtenden Schichten angeordnet werden – um Zehnerpotenzen höher als bei allen bisher bekannten Röntgenstrahlbelichtungsverfahren sein können, ist es mit dem erfindungsgemässen Verfahren ohne weiteres möglich, grössere Anzahlen von jeweils mehreren hundert Chips aufweisenden Halbleiterplättchen in wenigen Minuten zu belichten. Da die Belichtung der stehengebliebenen Bereiche der elektronenstrahlempfindlichen Schicht 4 und die Ausrichtung der jeweils in den Bereichen 8 aufzubringenden Muster mit an sich bekannten, sehr genauen und sehr leistungsfähigen Ausrichtungsverfahren erfolgen kann und der anschliessende, jeweils die gleichzeitige Belichtung von mehreren zehntausend Chips bewirkende Verfahrensschritt nur wenige Minuten in Anspruch nimmt, wird durch das beschriebene Verfahren die zur Belichtung einer vorgegebenen Anzahl von Chips erforderliche Zeit ganz wesentlich herabgesetzt. Von noch grösserer Bedeutung ist jedoch, dass das beschriebene Verfahren die Übertragung extrem feinstrukturierter und extrem genau ausgerichteter Muster ermöglicht, was mit den bisher bekannten Elektronenstrahl- und Röntgenstrahlbelichtungsverfahren nicht möglich war. Mit dem beschriebenen Verfahren ist es daher im Gegensatz zu allen vorbekannten Röntgenstrahlbelichtungsverfahren, die nur im Zusammenhang mit Einlagen-Lithographie, beispielsweise zur Herstellung von Magnetblasenspeichern verwendbar waren, möglich, integrierte Halbleiterschaltungen im Submikronbereich mit nahezu beliebig vielen einander überlagernden Muster ohne Ausrichtfehler (Overlayfehler) herzustellen.

## Patentansprüche

1. Verfahren zur Belichtung einer strahlungsempfindlichen Schicht mit Röntgenstrahlen durch mehrere individuelle, nur in bestimmten Bereichen auf die strahlungsempfindliche Schicht aufgebrachten Masken hindurch, mit folgenden Verfahrensschritten:

a) Aufbringen von mehreren Ausrichtmarkierungen (9) auf der Oberfläche des Substrats (1) ausserhalb der Chipbereiche (8).

b) Aufbringen einer ersten röntgenstrahlempfindlichen Schicht (2) auf das Substrat (1).

c) Aufbringen einer zweiten, über den eigentlichen Chipbereichen (Maske nach Fig. 6) liegenden Metallschicht (3).

d) Aufbringen einer dritten, elektronenstrahlempfindlichen Schicht (4).

e) Entfernen der ersten und dritten Schicht in einem die Ausrichtmarkierungen (9) enthaltenden Gebiet (16).

f) Ausrichtung der einzelnen Bereiche mit Hilfe der einzelnen Ausrichtmarkierungen.

g) Belichten der dritten Schicht (4) über den Chipbereichen mit Elektronenstrahlen entsprechend dem gewünschten Strukturmuster.

h) Entfernen der belichteten Bereiche der dritten Schicht (4) durch Entwickeln.

i) Entfernen der freigelegten Bereiche der zweiten Schicht (3) durch Ätzen.

j) Belichten der ersten Schicht (2) durch die als Maske dienende zweite Schicht (3).

2. Verfahren nach Anspruch 1, dadurch gekennzeichnet, dass die elektronenstrahlabsorbierende Schicht (3) als Schwermetallschicht ausgebildet ist.

3. Verfahren nach den Ansprüchen 1 und/oder 2, dadurch gekennzeichnet, dass die erste, röntgenstrahlempfindliche Schicht (2) aus einer 1 bis 10 µm dicken Photolackschicht besteht.

4. Verfahren nach einem oder mehreren der Ansprüche 1 bis 3, dadurch gekennzeichnet, dass die elektronenstrahlabsorbierende Schicht (3) 0,1 bis 0,5 µm dick ist.

5. Verfahren nach einem oder mehreren der Ansprüche 1 bis 4, dadurch gekennzeichnet, dass die dritte, elektronenstrahlempfindliche Schicht (4) als 0,1 bis 0,5 µm dicke Photolackschicht ausgebildet ist.

6. Verfahren nach einem oder mehreren der Ansprüche 1 bis 5, dadurch gekennzeichnet, dass die Belichtung der elektronenstrahlempfindlichen Schicht (4) mit kleinen Strahlspannungen von 1 bis 10 KV erfolgt, wobei die Elektronenstrahlen die zweite Schicht (3) nicht oder nur zum kleinen Teil durchdringen.

7. Verfahren nach einem oder mehreren der vorhergehenden Ansprüche, dadurch gekennzeichnet, dass die dritte, elektronenstrahlempfindliche Schicht (4) vor dem Belichten mit Röntgenstrahlen entfernt wird.

8. Verfahren nach einem oder mehreren der Ansprüche 1 bis 7, dadurch gekennzeichnet, dass die Photolackschichten (2, 4) durch Schleudern mit Abweichungen von der Solldicke von weniger als ±10% aufgebracht werden.

9. Verfahren nach einem oder mehreren der Ansprüche 1 bis 8, dadurch gekennzeichnet, dass die elektronenstrahlabsorbierende Schicht (3) durch Aufdampfen aufgebracht wird.

10. Verfahren nach einem oder mehreren der Ansprüche 1 bis 9, dadurch gekennzeichnet, dass die Belichtung der elektronenstrahlempfindlichen Schicht (4) durch Komplementärmasken erfolgt.

11. Verfahren nach einem oder mehreren der Ansprüche 1 bis 10, dadurch gekennzeichnet, dass die Belichtung der elektronenstrahlempfindlichen Schicht durch einen computergesteuerten Elektronenstrahl-Linienschreiber erfolgt.

12. Verfahren nach einem der Ansprüche 1 bis 11, dadurch gekennzeichnet, dass die Ausrichtmarkierungen (9) in Gitteranordnung (Fig. 3) auf den Schnittlinien angebracht sind, längs denen das Substrat in späteren Herstellschritten zerteilt wird.

13. Verfahren nach Anspruch 12, dadurch gekennzeichnet, dass zum Entfernen der ersten (2) und dritten (4) Schicht über den Ausrichtmarkierungen (9) eine Maske mit kreuzförmigen Öffnungen in gitterförmiger Anordnung (Fig. 7) verwendet wird.

14. Verfahren nach einem der Ansprüche 1 bis 13, dadurch gekennzeichnet, dass zum Entfernen der ersten (2) und dritten (4) Schicht eine Belichtung der betreffenden Gebiete mit Strahlung erfolgt, für die beide Schichten (2 und 4) empfindlich sind.

## Claims

1. A process for X-ray exposing a radiation sensitive layer through several individual masks applied only to particular areas of the radiation sensitive layer, comprising the following process steps:

a) applying several alignment marks (9) to the surface of the substrate (1) outside the chip areas (8),

b) applying a first, X-ray sensitive layer (2) to the substrate (1),

c) applying a second, metal layer (3) arranged on top of the actual chip areas (mask according to Fig. 6),

d) applying a third, electron beam sensitive layer (4),

e) removal of the first and the third layer in an area (16) containing the alignment marks,

f) aligning the individual areas with the aid of the individual alignment marks by electron beams,

g) exposing the third layer (4) on top of the chip areas by electron beams according to the desired structural pattern,

h) removing the exposed areas of the third layer (4) by developing,

i) removing the bared areas of the second layer (3) by etching,

j) exposing the first layer (2) through the second layer (3) acting as a mask.

2. The process according to claim 1, characterized in that the electron beam absorbing layer (3) is a heavy-metal layer.

3. The process according to the claims 1 and/or 2, characterized in that the first, X-ray sensitive layer (2) is a 1 to 10 μm thick photoresist layer.

4. The process according to any one or combination of claims 1 to 3, characterized in that the electron beam absorbing layer (3) is 0.1 to 0.5 μm thick.

5. The process according to any one or combination of claims 1 to 4, characterized in that the third, electron beam sensitive layer (4) is a 0,1 to 0.5 μm thick photoresist layer.

6. The process according to any one or combination of claims 1 to 5, characterized in that exposure of the electron beam sensitive layer (4) is effected at low beam voltages of 1 to 10 KV, the electron beams not penetrating or penetrating only a small part of the second layer (3).

7. The process according to any one or combination of the preceding claims, characterized in that the third, electron beam sensitive layer (4) is removed prior to X-ray exposure.

8. The process according to any one or combination of claims 1 to 7, characterized in that the photoresist layers (2, 4) are applied by spinning, with the deviations from the nominal thickness being less than ±10%.

9. The process according to any one or combination of claims 1 to 8, characterized in that the electron beam absorbing layer (3) is applied by vapour deposition.

10. The process according to any one or combination of claims 1 to 9, characterized in that the electron beam sensitive layer (4) is exposed through complementary masks.

11. The process according to any one or combination of claims 1 to 10, characterized in that exposure of the electron beam sensitive layer is effected by a computer-controlled electron beam recorder.

12. The process according to any one of the claims 1 to 11, characterized in that the alignment marks (9) forming a grid (Fig. 3) are applied to the lines along which the substrate is cut in later processing steps.

13. The process according to claim 12, characterized in that for removing the first (2) and the third (4) layer on top of the alignment marks (9) a mask is used which has cross-shaped openings arranged in the form of a grid (Fig. 7).

14. The process according to any one of the claims 1 to 13, characterized in that for removing the first (2) and the third (4) layer the respective areas are exposed to radiation to which the two layers (2 and 4) are sensitive.

## Revendications

1. Procédé pour exposer aux rayons X une couche sensible aux radiations au travers de plusieurs masques individuels appliqués seulement à des zones déterminées sur la couche sensible aux radiations, avec les étapes suivantes:

a) l'application de plusieurs marques d'alignement (9) sur la surface du substrat (1) en dehors des zones de microplaquette (8),

b) l'application d'une première couche sensible aux rayons X (2) sur le substrat (1),

c) l'application d'un deuxième couche de métal (3) s'étendant sur les zones de microplaquette réelles (selon le masque de la Figure 6),

d) l'application d'une troisième couche sensible à und faisceau d'électrons (4),

e) le retrait de la première et de la troisième couche dans une zone (16) portant les marques d'alignement (9),

f) l'alignement des zones individuelles à l'aide des marques d'alignement individuelles par des faisceaux d'électrons,

g) l'exposition de la troisième couche (4) sur les zones de microplaquettes, à l'aide de faisceaux d'électrons correspondant à la configuration de structure désirée,

h) le retrait des zones exposées de la troisième couche (4) par développement,

i) le retrait des zones décourvertes de la deuxième couche (3) par décapage,

j) l'exposition de la première couche (2) au travers de la deuxième couche (3) faisant fonction de masque.

2. Procédé selon la revendication 1, caractérisé en ce que la couche d'absorption du faisceau d'électrons (3) est une couche de métal lourd.

3. Procédé selon les revendications 1 et/ou 2, caractérisé en ce que la première couche sensible aux rayons X (2) est une couche caractérisé en ce que la première couche sensible aux rayons X (2) est une couche photorésistante d'une épaisseur de 1 à 10 μm.

4. Procédé selon l'une ou plusieurs des revendications 1 à 3, caractérisé en ce que la couche d'absorption du faisceaux d'électrons (3) a une épaisseur de 0,1 à 0,5 μm.

5. Procédé selon l'une ou plusieurs des revendications 1 à 4, caractérisé en ce que la troisième couche sensible au faisceau d'électrons (4) est une couche photorésistante d'une épaisseur de 0,1 à 0.5 μm.

6. Procédé selon l'une ou plusieurs des revendications 1 à 5, caractérisé en ce que l'exposition de la couche sensible au faisceau d'électrons (4) est effectuée à de faibles tensions de rayon de 1 à 10 KV, les faisceaux d'électrons ne pénétrant pas ou ne pénétrant seulement la deuxième couche (3) dans une petite partie.

7. Procédé selon l'une ou plusieurs des revendications précédentes, caractérisé en ce que la troisième couche sensible au faisceau d'électrons (4) est retirée avant l'exposition aux rayons X.

8. Procédé selon l'une ou plusieurs des revendications 1 à 7, caractérisé en ce que les couches photorésistantes (2, 4) sont appliquées par centrifugation, avec des écarts par rapport à l'épaisseur nominale inférieurs à ±10%.

9. Procédé selon l'une ou plusieurs des revendications 1 à 8, caractérisé en ce que la couche d'absorption du faisceau d'électrons (3) est appliquée par dépôt de vapeur.

10. Procédé selon l'une ou plusieurs des revendications 1 à 9, caractérisé en ce que la couche sensible au faisceau d'électrons (4) est exposée au travers de masques complémentaires.

11. Procédé selon l'une ou plusieurs des revendications 1 à 10, caractérisé en ce que l'exposition de la couche sensible au faisceau d'électrons est effectuée par un traceur de lignes à faisceau d'électrons commandé par calculateur.

12. Procédé selon l'une ou plusieurs des revendications 1 à 11, caractérisé en ce que les marques d'alignement (9) formant une grille (Figure 3) sont appliquées aux lignes de découpage le long desquelles le substrat est découpé au cours d'étapes ultérieures.

13. Procédé selon la revendication 12, caractérisé en ce que pour le retrait de la première (2) et de la troisième (4) couches sur les marques d'alignement (9), on utilise un masque qui présente des ouvertures en forme de croix et disposées en grille (Figure 7).

14. Procédé selon l'une quelconque des revendications 1 à 13, caractérisé en ce que pour le retrait de la première (2) et de la troisième (4) couches, les zones respectives sont exposées à une radiation à laquelle les deux couches (2 et 4) sont sensibles.

FIG.1

FIG.2 { A B C

**FIG.3**

**FIG.4**

**FIG.5**

A

B

C

D

FIG.6

FIG.7